# EUROPEAN PATENT SPECIFICATION

(11) **EP 1 490 450 B1**
(45) Date of publication and mention of the grant of the patent: **30.08.2006**
(21) Application number: 03711124.2
(22) Date of filing: 19.02.2003
(51) Int. Cl.: C09J 163/00, C09J 129/10, C08G 59/68, H01R 4/04

(54) **CATIONIC POLYMERIZABLE ADHESIVE COMPOSITION AND ANISOTROPICALLY ELECTROCONDUCTIVE ADHESIVE COMPOSITION**
KATIONISCH POLYMERISIERBARE KLEBSTOFFZUSAMMENSETZUNG UND ELEKTRISCH ANISOTROP LEITENDE KLEBSTOFFZUSAMMENSETZUNG
COMPOSITION ADHESIVE CATIONIQUE POLYMERISABLE ET COMPOSITION ADHESIVE ANISOTROPIQUEMENT ELECTROCONDUCTIVE

(30) Priority: 01.04.2002 JP 2002099071
(43) Date of publication of application: 29.12.2004
(73) Proprietor: 3M Innovative Properties Company, St. Paul, MN 55133-3427 (US)
(72) Inventor: YAMAGUCHI, Hiroaki, Hachiohji-shi. Tokyo 192-0372 (JP); AKIYAMA, Ryota,, Tokyo 192-0372 (JP)
(74) Representative: Vossius & Partner
(86) International application number: PCT/US2003/004944
(87) International publication number: WO 2003/085062

(56) References cited:
- WO-A-99/09101
- GB-A- 1 554 429
- US-A- 5 362 421
- US-A- 5 453 450
- US-A- 5 486 655
- PATENT ABSTRACTS OF JAPAN vol. 018, no. 032 (C-1154), 18 January 1994 (1994-01-18) & JP 05 262816 A (NIPPON OIL & FATS CO LTD), 12 October 1993 (1993-10-12)
- PATENT ABSTRACTS OF JAPAN vol. 013, no. 302 (C-616), 12 July 1989 (1989-07-12) & JP 01 090269 A (FUJIKURA LTD), 6 April 1989 (1989-04-06)
- PATENT ABSTRACTS OF JAPAN vol. 1997, no. 03, 31 March 1997 (1997-03-31) & JP 08 295830 A (SEKISUI CHEM CO LTD), 12 November 1996 (1996-11-12)
- PATENT ABSTRACTS OF JAPAN vol. 2000, no. 19, 5 June 2001 (2001-06-05) & JP 2001 048921 A (DAICEL CHEM IND LTD), 20 February 2001 (2001-02-20)
- DATABASE WPI Week 199348, Derwent Publications Ltd., London, GB; Class A25, AN 1993-383661 & JP 5 287 696 A (NIPPON KAYAKU) 02 November 1993
- DATABASE WPI Week 200105, Derwent Publications Ltd., London, GB; Class A21, AN 2001-034285 & JP 2000 230038 A (TOSHIBA) 22 August 2000

## Description

The present invention relates to a cationic polymerizable adhesive composition and an amisotropically electroconductive adhesive composition.

The present invention further relates to an adhesive film and an anisotropically electroconductive adhesive film.

Cationic polymerizable compositions making use of cationic polymerization are being widely used, for example, in the field of coating material, ink, and adhesive. Particularly in the use for an adhesive, the cationic polymerizable composition is advantageous because of its high curing rate and freeness of oxygen hindrance. However, a cationic polymerization catalyst is required to initiate the cation polymerization reaction. Also, in a composition wherein a compound having the cationic polymerizability and a cationic polymerization catalyst coexist, there arise problems that gelling occurs during the storage because of its high reactivity and a pot life is reduced.

As a means to solve these problems, the compound having the cationic polymerizability has hitherto been used immediately before using the cationic polymerization catalyst. In this case, since the composition is of the two-pack type and components must be mixed immediately before use, the operation is complicated. There is also such a limitation that the composition must be stored and transported at low temperature, and used up within a given period after the manufacture. Therefore, a cationic polymerizable composition capable of being stored at normal temperature in a one-pack state for a long time has been required and various methods for storing the composition have been studied.

To enhance the storage stability of the cationic polymerizable composition, for example, stabilizers have hitherto been used. The stabilizer in the cationic polymerizable composition is generally an electron-donating Lewis base. A strong Lewis base replaces the counter anions of the cationic polymerization catalyst, thereby reducing the activity of the catalyst itself. On the other hand, a comparatively weak Lewis base traps a Lewis acid generated from the catalyst and cationic species during the polymerization, thereby delaying the reaction. By selecting such a Lewis base as the stabilizer and adding it to the cationic polymerizable composition, desired reactivity is obtained and the storage stability is improved (Japanese Unexamined Patent Publication (Kokai) No. 4-227625; Japanese National Publication (Kohyo) No. 8-511572; and Japanese Unexamined Patent Publication (Kokai) No. 5-262815).

Japanese Unexamined Patent Publication (Kokai) Nos. 7-90237 and 9-291260 describe the technique using a sulfonium salt and an epoxy resin as a cationic polymerization type curing agent. Furthermore, the method of making a cationic polymerizable catalyst latent using a physical technique for the purpose of improving the storage stability is studied. The method includes, for example, the method of forming into microcapsules (Japanese Unexamined Patent Publication (Kokai) No. 6-73163) wherein an organic phosphine compound is enclosed with a polymer in the form of particles and the method of achieving the one-pack storage stability by adsorbing on a compound having pores such as zeolite.

Furthermore, Japanese Unexamined Patent Publication (Kokai) No. 2000-230038 describes a cationic polymerization catalyst which can be dissolved or deposited reversibly by heating or cooling.

However, all compositions using these catalyst types exhibit low reactivity and poor storage stability. Also, they have drawbacks that additional operations are required to encapsulate. In an adhesive film formed from these compounds, exposure to light, which activates the catalyst, must be prevented to prevent the catalyst from activating until it is actually used and, therefore, it is required to enhance the storage stability.

In US-A-5,486,655 an adhesive for multiple wire wiring boards comprising certain amounts of (a) an epoxy resin having a molecular weight of 5,000 or more and being solid at room temperature, (b) a polyfunctional epoxy resin having at least three epoxy groups, (c) an intramolecular epoxy modified polybutadiene having at least three epoxy groups, (d) a cationic photopolymerization initiator, and (e) a tin compound is described. US-A-5,362,421 discloses a certain anisotropically conductive adhesive composition comprising (a) a cationically polymerizable monomer; (b) a thermoplastic resin, essentially free of nucleophilic or metal-complexing groups; (c) optionally, an alcohol-containing material; (d) a specific thermal initiator system; (e) conductive particles; and (f) optionally, a silane coupling agent.

On the other band, in a liquid crystal display device, the electrode part of a glass-made display panel and a flexible circuit called TCP (Tape Carrier Package) having mounted thereon a driving IC necessary for actuating the display panel are connected by the thermocompression bonding with the intervention of anisotropically electroconductive adhesive film. The connection pitch thereof is usually from 100 to 200 µm. However, as the display part becomes highly definite, the connection pitch becomes finer and in recent years, a connection pitch of 50 µm or less is demanded. This finer connection pitch causes a problem of pitch slippage by the expanding and shrinking behavior of TCP due to heat at the thermocompression bonding. In order to solve this problem, an anisotropically electroconductive adhesive film capable of thermocompression bonding at a lower temperature is being demanded. Furthermore, for improving the productivity, an anisotropically electroconductive adhesive film capable of thermocompression bonding within a shorter time is also being demanded. For the purpose of satisfying these requirements, an anisotropically electroconductive adhesive film using a cationic polymerization mechanism and having high reactivity has been proposed.

For example, Japanese National Publication (Kohyo) No. 8-511570 describes an anisotropically electroconductive adhesive composition comprising a curable epoxy resin, a thermoplastic resin, an organic metal complex cation, a stabilizing additive, a curing rate enhancer and electroconductive particles, and states that heat-curing at a temperature of from 120 to 125°C can be attained. However, such an anisotropically electroconductive adhesive composition was not satisfactory in the storage stability.

In one embodiment, according to the present invention, in a cationic polymerizable adhesive composition comprising (A) a cationic polymerizable monomer selected from an epoxy monomer, a vinyl ether monomer of a mixture thereof; (B) a cationic polymerization catalyst being an iron-arene complex having an absorption peak in a visible light range of from 360 to 380 nm and (C) a solvent for the cationic polymerization catalyst, a mixture of a good solvent and a poor solvent for the cationic polymerization catalyst is used as the solvent (C), a good solvent being a solvent wherein the cationic polymerization catalyst has a solubility of 5 % or more at room temperature, a bad solvent being a solvent wherein the cationic polymerization catalyst has a solubility of less than 5 % at room temperature, and wherein a weight ratio of the good solvent to the poor solvent is within a range from 5:95 to 60:40.

According to the present invention, an anisotropically electroconductive adhesive composition comprising the above-described cationic polymerizable adhesive composition and electroconductive particles is also provided.

According to the present invention, an adhesive film formed by applying the above-described cationic polymerizable adhesive composition or anisotropically electroconductive adhesive composition onto a separator and drying the coating film is also provided.

As described above, the cationic polymerizable adhesive composition of the present invention is constructed by (A) a cationic polymerizable monomer; (B) a cationic polymerization catalyst; and (C) a solvent for the cationic polymerization catalyst. Respective constituent components are described below.

The cationic polymerizable monomer is selected from an epoxy monomer, a vinyl ether monomer, or a mixture thereof. Examples of the epoxy monomer include 1,2-cyclic ether, 1,3-cyclic ether, and 1,4-cyclic ether each having a cationic polymerizable functional group, however, the epoxy monomer is limited to monomers not having a group of inhibiting the cationic polymerization, for example, a functional group containing amine, sulfur, or phosphorous. This epoxy monomer is preferably an alicyclic epoxy resin or a glycidyl group-containing epoxy resin.

The alicyclic epoxy resin is a compound having on average two or more alicyclic epoxy groups within the molecule and examples thereof include those having two epoxy groups within the molecule, such as vinylcyclohexene dioxide (for example, ERL-4206, produced by Union Carbide Japan); 3,4-epoxycyclohexylmethyl-3,4-epoxycyclohexane carboxylate (for example, UVR-6105 and UVR-6110, produced by Union Carbide Japan); bis(3,4-epoxycyclohexyl)adipate (for example, UVR-6128, produced by Union Carbide Japan); 2-(3,4-epoxycyclohexyl-5,5-spiro-3,4-epoxy)cyclohexarie-meta-dioxane (for example, ERL-4234, produced by Union Carbide Japan); and poly functional alicyclic epoxy resins having 3, 4, or more epoxy groups within, the molecule (for example, Epolide, GT, produced by Daicel Chernical-Industries;Ltd.).

The alicyclic epoxy resin usually has an epoxy equivalent of 90 to 500, preferably from 100 to 400, more preferably from 120 to 300, most preferably from 210 to 235. If the epoxy equivalent is less than 90, the toughness after thermosetting and the adhesive strength may be reduced to cause decrease in the connection reliability, whereas if the epoxy equivalent exceeds 500, the viscosity of the entire system is excessively increased, as a result, poor flowability may be exhibited at the thermocompression bonding or the reactivity may be lowered, thereby reducing the connection reliability.

The glycidyl group-containing epoxy resin is a compound having on average two or more glycidyl groups within the molecule and examples thereof include bisphenol A-type glycidyl ether (for example, Epikote 828, produced by Yuka Shell Epoxy K.K.) and phenol novolak-type epoxy (for example, Epikote 154, produced by Yuka Shell Epoxy K.K.).

The glycidyl group-containing epoxy resin usually has an epoxy equivalent of 170 to 5,500, preferably from 170 to 1,000, more preferably from 170 to 500, most preferably from 175 to 210. If the epoxy equivalent is less than 170, the toughness after thermosetting and the adhesive strength may be lowered, whereas if the epoxy equivalent exceeds 5,500, the viscosity of the entire system is excessively increased, as a result, poor flowability may be exhibited at the thermocompression bonding or the reactivity may be lowered, thereby reducing the connection reliability.

The vinyl ether monomer has a high electron density of double bond and produces a very stable carbocation, therefore, this monomer has a high reactivity in the cationic polymerization. For not inhibiting the cationic polymerization, the vinyl ether monomer is limited to those not containing nitrogen and examples thereof include methyl vinyl ether, ethyl vinyl ether, tert-butyl vinyl ether, isobutyl vinyl ether, triethylene glycol divinyl ether, and 1,4-cyclohexane dimethanol divinyl ether. Preferred examples of the vinyl ether monomer include triethylene glycol divinyl ether (for example, Rapi-Cure DVE.3, produced by ISP Japan K.K.) and cyclohexane dimethanol divinyl ether (for example, Rapi-Cure CHVE, produced by ISP Japan K.K.).

These epoxy monomers and vinyl ether monomers may be used individually or as a mixture thereof. A plurality of epoxy monomers or vinyl ether monomers may be used. Particularly, a mixture of an alicyclic epoxy resin and a glycidyl group-containing epoxy resin is preferably used. The alicyclic epoxy resin has an action of improving the rapid curability and low-temperature curability of the adhesive composition and because of its low viscosity, also has an action of elevating the adhesion of the adhesive composition to an adherend. On the other hand, the glycidyl group-containing epoxy resin has an action of prolonging the pot life of the adhesive composition after activation. Accordingly, by using the alicyclic epoxy resin and the glycidyl group-containing epoxy resin in combination, the obtained adhesive composition can exhibit in good balance both the low-temperature rapid curability of the alicyclic epoxy resin and the long storage stability at room temperature of the glycidyl group-containing epoxy resin. The ratio of the alicyclic epoxy resin/glycidyl group-containing epoxy resin blended is usually 5:95 to 98:2, preferably 40:60 to 94:6, more preferably 50:50 to 90:10, most preferably 50:50 to 80:20. If the amount of the alicyclic epoxy resin is less than 5% by weight based on the total amount of the alicyclic epoxy resin and the glycidyl group-containing epoxy resin, the curing properties at low temperatures may be reduced to fail in providing sufficiently high adhesive strength or connection reliability, whereas if the amount of the alicyclic epoxy resin exceeds 98% by weight, a curing reaction readily proceeds even at near room temperature and therefore, the pot life after activation may be shortened. The amount of the cationic polymerizable monomer blended is preferably from 10 to 90 parts per 100 parts by weight of the entire composition.

The cationic polymerization catalyst is a compound of producing cationic active species such as Lewis acid upon irradiation with ultraviolet rays or under heating and catalyzing a ring-opening reaction of the epoxy ring. The cationic polymerization catalyst is an iron-arene complexe iron-arene complexes have thermal stability, and specific examples thereof include xylene-cyclopentadienyl iron(II) (tris (trifluoromethylsulfonyl)methide, cumene-cyclopentadienyl iron(II) hexafluorophosphate, bis(etha-mesithylene) iron(II) tris(trifluoromethylsulfonyl)methide, and bis(ethamesithylene) iron(II) hexafluoroentimonate. In the adhesive film of the present invention, the storage stability can be exhibited even in a visible range (from 360 to 830 nm). The cationic polymerization catalyst has absorption wavelength in this visible range. The other examples of cationic polymerization catalyst are those disclosed in Japanese National Publication (Kohyo) No. 8-511572, Japanese National Publication (Kohyo) No. 11-501909, and Japanese Unexamined Patent Publication (Kokai) No. 59-108003.

The amount of the cationic polymerization catalyst used is usually from 0.05 to 10.0 parts by weight, preferably from 0.075 to 7.0 parts by weight, more preferably from 0.1 to 4.0 parts by weight, most preferably from 1.0 to 2.5 parts by weight, per 100 parts by weight of the cationic polymerizable monomer. If the amount used is less than 0.05 parts by weight, the curing properties at low temperatures may be lowered to fail in providing sufficiently high adhesive strength or connection reliability, whereas if it exceeds 10.0 parts by weight, a curing reaction readily proceeds even at near room temperature and therefore, the storage stability at room temperature may decrease.

The solvent for the cationic polymerization catalyst includes a good solvent and a poor solvent for this cationic polymerization catalyst. As used herein, the term "good solvent" means an organic solvent in which the cationic polymerization catalyst can dissolve, while the term "poor solvent" means an organic solvent in which the cationic polymerization catalyst can not dissolve. Judgment of dissolution can be confirmed by the fact that no precipitate is observed in a mixed solution of an organic solvent and a catalyst, and is conducted according to the criterion whether or not the solvent can dissolve about 5% of the cationic polymerization catalyst at room temperature. When the solubility is 5% or more, it is a good solvent.

The good solvent and poor solvent can be appropriately selected depending on the cationic polymerization catalyst used according to the above-described criterion. For example, when using bis(eta-mesitylene) iron(II) tris(trifluoromethylsulfonyl) methide as the cationic polymerization catalyst, combinations of the good solvent and the poor solvent, for example, acetone and toluene, methyl ethyl ketone and toluene, and acetone and xylene can be used.

The catalyst has a resulting particle size of no greater than 5 microns and most preferably a particle size from more than 0 microns to 0.1 microns in the adhesive film which is provided by the present invention.

The good solvent and the poor solvent are used in a weight ratio within a range from 5:95 to 60:40, and preferably from 10:90 to 50:50. If the amount of the good solvent is small, the cationic polymerization catalyst in the form of coarse particles having a particle diameter of 5 µm or more is deposited, thus making it impossible to conduct uniform cationic polymerization. On the other hand, if the amount of the poor solvent is small, the storage stability is not improved. The good solvent has preferably an evaporation rate higher than that of the poor solvent. These organic solvents may be used alone, or a mixture of these organic solvent may be used. Even if the good solvent alone can not serve as a good solvent to the cationic polymerization catalyst; a mixture of the good solvent and a so-called cosolvent can be used as the good solvent.

By mixing cationic polymerizable monomers, cationic polymerization catalysts, and solvents, the cationic polymerizable adhesive composition of the present invention can be obtained. The anisotropically electroconductive adhesive composition can be obtained by adding electroconductive particles to this adhesive composition.

Examples of the electroconductive particles which can be used include electroconductive particles such as carbon particle and metal particle of copper, nickel, gold, tin, zinc, platinum, palladium, iron, tungsten, molybdenum, solder, or the like. These particles may also be used after further covering the particle surface with an electroconductive coating of a metal or the like. Furthermore, non-electroconductive particles of glass bead, silica, graphite, ceramic, or a polymer such as polyethylene, polystyrene, phenol resin, epoxy resin, acryl resin, and benzoguanamine resin, the surface of which is covered with an electroconductive coating of a metal or the like, may also be used. The shape of the electroconductive particle is not particularly limited but a nearly spherical shape is usually preferred. This particle may have a slightly rough or spiked surface. The shape may also be either ellipsoidal or long cylindrical.

The average particle size of the electroconductive particles used may vary depending on the width of electrode used for connection and the spacing between adjacent electrodes. For example, in the case where the electrode width is 50 µm and the spacing between adjacent electrodes is 50 µm (namely, the electrode pitch is 100 µm), the average particle size is suitably on the order of 3 to 20 µm. By using an anisotropically electroconductive adhesive film having dispersed therein electroconductive particles having an average particle size within this range, sufficiently good electroconductive characteristics can be attained and at the same time, short circuiting between adjacent electrodes can be satisfactorily prevented. Since the pitch of electrodes used for connection of circuit substrates with each other is usually from 50 to 1,000 µm, the average particle size of the electroconductive particles is preferably from 2 to 40 µm.If the average particle size is less than 2 µm, the particles are buried in pits on the electrode surface and may not function as an electroconductive particle, whereas if it exceeds 40 µm, short circuiting is readily generated between adjacent electrodes.

The amount of the electroconductive particles added may be varied depending on the area of electrode used and the average particle size of electroconductive particles. A satisfactory connection is usually attained when a few (for example, from 2 to 10) electroconductive particles are present per electrode. In the case of further reducing the electrical resistance, the electroconductive particles may be blended in the adhesive such that from 10 to 300 electroconductive particles are present. Furthermore, in the case where a high pressure is imposed at the time of thermocompression bonding, the number of electroconductive particles on electrode may be increased to 300 to 1,000 to disperse the pressure and thereby achieve a satisfactory connection. The amount of electroconductive particles is usually from 0.1 to 30% by volume, preferably from 0.5 to 10% by volume, more preferably from 1 to 5% by volume, based on the total volume of the adhesive excluding the electroconductive particles. If the amount is less than 0.1 % by volume, electroconductive particles are probably absent on the electrode at the time of bonding and the connection reliability may decrease, whereas if the amount exceeds 30% by volume, short circuiting is readily generated between adjacent electrodes.

The cationic polymerizable adhesive composition and anisotropically electroconductive adhesive composition of the present invention may contain other additives and modifiers according to the end use in addition to the above-described components. Examples of the additives which can be added to the adhesive compositions include a cationic polymerization accelerator (for example, di-tert-butyl oxalate), an antioxidant (for example, hindered phenol-based antioxidant), a coupling agent (for example, a silane coupling agent such as γ-glycidoxypropyl trimethoxysilane and β-(3,4-epoxycyclohexyl)ethyl trimethoxysilane), and a stabilizer. The stabilizer suppresses or inhibits the cationic polymerization reaction by trapping the Lewis acid or the like serving as cationic active species in the cationic polymerization, and specific examples thereof include crown ethers such as 15-crown-5, 1,10-phenanthroline and derivatives thereof, toluidines such as N,N-diethyl-meta-toluidine, phosphines such as triphenylphosphine, 2,2'-dipyridyl, and acid amides.

As the modifier, diols (for example, bis(phenoxyethanol)fluorene), a tackifier, a thermoplastic elastomer or resin, a filler (for example, fumed silica) and an impact resistance modifier can be added. The tackifying effect of the adhesion composition can be efficiently enhanced by using fused silica whose surface is hydrohobized with a trimethylsilyl group, among fumed silica. There can also be used, as the impact resistance modifier, so-called core shell particles wherein an outer shell is made of a polymer having good compatibility with a thermosetting resin such as epoxy resin and a core material is made of a rubber component.

The thermoplastic elastomer or resin is preferably incorporated when the cationic polymerizable adhesive composition of the present invention is formed into an adhesive film. The thermoplastic elastomer or resin increases the film formability of the adhesive film and at the same time, improves the impact resistance of the adhesive film, relaxes the residual internal stress generated by the curing reaction and elevates the bonding reliability. The thermoplastic elastomer is one kind of polymer compounds commonly called a thermoplastic elastomer, which are composed of a hard segment as a confined phase and a soft segment expressing rubber elasticity, at a certain temperature or less. Examples of this elastomer include a styrene-based thermoplastic elastomer. The styrene-based elastomer is a block copolymer containing, for example, a styrene unit in the hard segment and a polybutadiene or polyisoprene unit in the soft segment. Typical examples thereof include a styrene-butadiene-styrene block copolymer (SBS) and a styreneisoprene-styrene block copolymer (SIS) and additionally include a styrene-(ethylenebutylene)-styrene block copolymer (SEBS) and a styrene-(ethylene-propylene)-styrene block copolymer (SEPS), where the diene component in the soft segment is hydrogenated. Furthermore, styrene-based thermoplastic elastomers having a reactive group, such as elastomer epoxy-modified by glycidyl methacrylate and elastomer in which the unsaturated bond of conjugate diene is epoxidized, may also be used. The elastomer having a reactive group is elevated in the compatibility with the epoxy resin because of high polarity of the reactive group and therefore, broadened in the latitude of blending with epoxy resin and at the same time, since the reactive group is incorporated into the crosslinked structure by the crosslinking reaction with epoxy resin, the resistance against heat and humidity after the curing is ensured and thereby the bonding reliability can be improved. Examples of the epoxidized styrene-based elastomer include Epofriend A1020 (produced by Daicel Chemical Industries, Ltd.).

In the present invention, a thermoplastic resin may also be used in place of the thermoplastic elastomer. The adhesive must be eliminated by fluidization at the thermocompression bonding of the adhesive film, so that good electrical connection can be attained between circuits on the bonded substrates. Therefore, the thermoplastic resin preferably has a T_{g} of the thermocompression bonding temperature (for example, from 100 to 130°C) or less. This thermoplastic resin is limited to those which do not have a group which inhibits the cationic polymerization reaction, for example, a functional group including amine, sulfur, or phosphor. Furthermore, a thermoplastic resin, which is soluble in the organic solvent used and has good compatibility with the cationic polymerizable monomer, is particularly preferred. Examples of this thermoplastic resin include polyvinyl acetal resin, polyvinyl butyral resin, acrylic resin, methacrylic resin, polyester resin, phenoxy resin, novolak resin, polystyrene resin, polycarbonate resin, polysulfone resin, and a combination thereof.

The amount of the thermoplastic elastomer or resin is usually from 10 to 900 parts by weight, preferably from 20 to 500 parts by weight, more preferably from 30 to 200 parts by weight, most preferably from 40 to 100 parts by weight, per 100 parts by weight of the cationic polymerizable monomer. If the amount is less than 10 parts by weight, the adhesive composition may be reduced in the film formability, whereas if the amount exceeds 900 parts by weight, the adhesive composition as a whole is reduced in the flowability at low temperatures and poor contact results between the electroconductive particles and the circuit substrate at the bonding, causing increase in the electrical resistance or reduction in the connection reliability and sometimes also decrease in the bonding strength.

A heat-conductive adhesive film can also be obtained by adding heat-conductive fillers, for example, particles of alumina, silica, boron nitride, magnesium oxide, and carbon fiber to the cationic polymerizable adhesive composition of the present invention.

Cationic polymerizable adhesive compositions and anisotropically electroconductive adhesive compositions are preferably used in the form of a film. This film can be made, for example, in the following manner. First, a cationic polymerizable monomer and, if necessary, the above-described thermoplastic resin which can improve the film formability, and a poor solvent and a good solvent are sufficiently mixed with stirring to obtain an adhesive solution. Optionally, to form an anisotropically electroconductive adhesive composition, electroconductive particles, as described previously, can be added to the obtained adhesive solution as shown in Examples E1 to E5. Separately, a cationic polymerization catalyst and a good solvent are mixed to obtain a uniform catalyst solution. These solutions are mixed to prepare an adhesive solution and the adhesive solution is applied onto a separator (for example, a silicone-treated polyester film), using a proper means such as knife coater and then the coating film is dried to obtain a film. In the drying operation, the polymerization catalyst dissolved in the adhesive solution is gradually recrystallized and uniformly precipitated in the form of fine particles in the film. As a result, the storage stability is considered to be improved. The thickness of the film thus formed is preferably within a range from 5 to 100 µm so as to fill necessarily and sufficiently without forming any space in the connection portion when the substrates are connected by the thermocompression bonding.

After disposing the adhesive film on a substrate (pre-bonding), the other substrate to be bonded is thermocompression-bonded onto the adhesive composition by a press-bonding head (final-bonding), whereby two substrates are bonded.

When a cationic polymerizable catalyst having an absorption wavelength in a range of light, especially a visible range (from 360 to 830 nm) is dissolved in a cationic polymerizable monomer, a portion of cationic polymerization catalyst molecules is decomposed by exposure to visible light in a given dose or more to form cationic species, and the cationic polymerizable monomer is gradually polymerized even at room temperature. Therefore, when a conventional cationic polymerizable adhesive is exposed to light under a fluorescent lamp at room temperature for one day, the reaction proceeds excessively and the tackiness and flowability are lowered, and thus a function as an adhesive is drastically lowered. However, even if the adhesive film made of the cationic polymerizable composition of the present invention is exposed under the same conditions for one day, the reaction proceeds slowly and a function as the adhesive can be maintained.

### EXAMPLES

### Production of Anisotropically Electroconductive Adhesive Film

1.0 g of an alicyclic epoxy resin (Cyracure UVR6128, trade name, produced by Union Carbide Japan Ltd., epoxy equivalent: 200), 5.0 g of a glycidyl group-containing phenol-novolak epoxy resin (Epikote 154, trade name, produced by Yuka Shell Epoxy Ltd., epoxy equivalent: 178), 4.0 g of a phenoxy resin (PKHC, produced by Phenoxy Associates Ltd., OH equivalent: 284) and 0.00.9 g of N,N-dimethyl-m-toluidine were mixed with 11.0 g of a mixed organic solvent of a good solvent and a poor solvent shown in Table 1 and the mixture was stirred until a uniform solution was formed. Thereto, electroconductive particles (particles obtained by providing a nickel layer on the surface of a divinylbenzene copolymer and further stacking gold thereon, average particle size: 5 µm) were added to occupy 3% by volume in the final solid and continuously stirred until the electroconductive particles were thoroughly dispersed. Separately, 0.06 g of a cationic polymerization catalyst (bis(eta-mesitylene) iron(II)-tris(trifluoromethylsulfonyl)methide), 0.2 g of a silane coupling agent (Silane Coupling Agent A 187, produced by Nippon Unicar Co., Ltd., γ-glycidoxypropyl trimethoxysilane) and 0.6 g of a good solvent were mixed and stirred until a uniform solution was formed, and this solution was added to the dispersion solution prepared above, followed by further stirring. The thus-obtained dispersion solution of the anisotropically electroconductive adhesive composition was applied onto a silicone-treated polyester film as a separator, using a knife coater and then dried at 65°C for 10 minutes to obtain an anisotropically electroconductive adhesive film having a thickness of 25 µm (E1 to 5).

For the purpose of comparison, anisotropically electroconductive adhesive films were produced in the same manner as in E1 except for changing a weight ratio of the good solvent to the poor solvent to 70:30 (C1), or in the same manner as in E1 except for using no poor solvent and changing the amount of the good solvent to 100% (C2 and C3), or in the same manner as in E 1 except for using no good solvent and changing the amount of the poor solvent to 100% (C4 and C5).

The thus-produced anisotropically electroconductive adhesive films having a width of 2 mm and a length of 4 cm each was tacked onto a 0.7 mm thick glass plate with ITO (Indium Tin Oxide) film and bonded by thermocompression at 60°C and a pressure of 1.0 MPa for 4 seconds and then, the separator polyester film was peeled off (pre-bonding). Thereafter, a flexible circuit comprising a 25 µm thick polyimide film having disposed thereon gold-plate copper traces to a conductor pitch of 70 µm, a conductor width of 35 µm and a thickness of 12 µm was positioned and fixed on the anisotropically electroconductive adhesive film pre-bonded above. These were heat-pressed using an ordinarily heating-type compressor under the conditions such that the anisotropically electroconductive adhesive film portion was heated at 180°C and 1.5 MPa for 10 to 20 seconds, thereby completing the circuit connection (final-bonding).

### Evaluation of Adhesive Strength

The flexible circuit thus-formed by the thermocompression bonding onto a glass plate with ITO film was cut into a width of 5 mm and pulled in the direction of 90° from' the glass plate with ITO film at a rate of 50 mm/minute and the maximum value thereof was recorded.

### Evaluation of Exothermic Property by DSC (Differential Scanning Calorimeter)

If the adhesive composition has poor storage stability, the curing reaction proceeds during the storage and in the measurement by DSC, this appears as an increase of exotherm energy. Accordingly, the exotherm energy was measured in the range from 50 to 200°C. At the measurement, the temperature-elevating rate was set to 10°C/minute.

### Evaluation of Connection State

The connection resistance between the glass plate with ITO film and the flexible circuit was measured using a digital multi-meter.

### Evaluation of Storage Stability

An anisotropically electroconductive film on a separator was placed so that the anisotropically electroconductive film faces a white fluorescent lamp, and then allowed to stand at room temperature for 24 hours. Illuminance on the film surface was controlled to 1000 Ix (after storage).

The evaluation results are shown in Table 1 and Table 2.

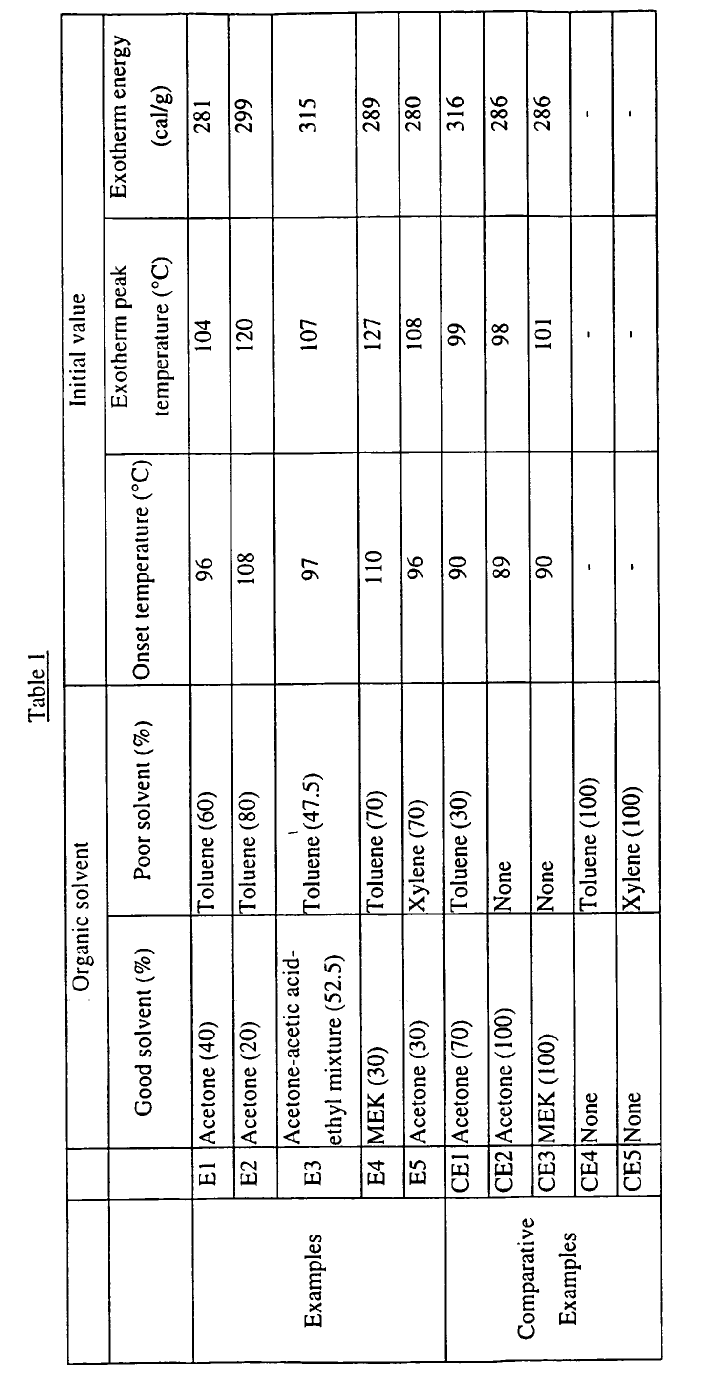

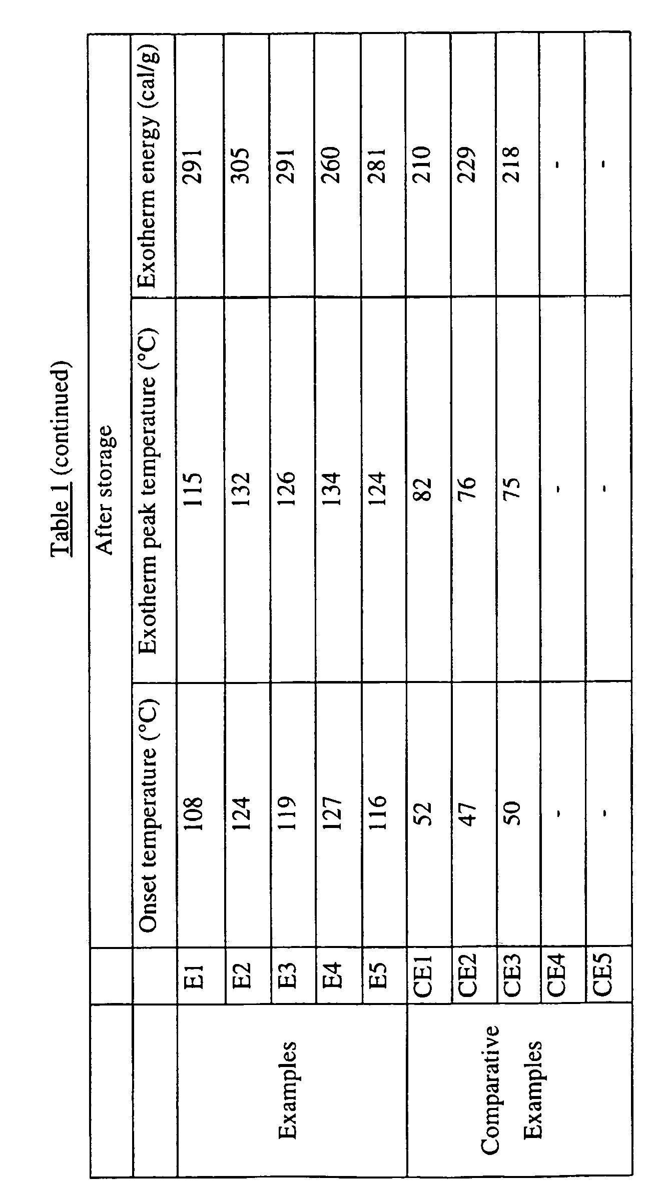

**Table 2**

| | | Organic solvent | | Initial value | | After storage | |
|---|---|---|---|---|---|---|---|
| | | Good solvent (%) | Poor solvent (%) | Average connection resistance (Ω) | Average adhesive strength (N/cm) | Average connection resistance (Ω) | Average adhesive strength (N/cm) |
| Examples | E1 | Acetone (40) | Toluene (60) | 1.8 | 7.5 | 1.9 | 6.6 |
| | E2 | Acetone (20) | Toluene (80) | 1.6 | 6.3 | 1.6 | 5.3 |
| | E3 | Acetone-acetic acid-ethyl mixture (52.5) | Toluene (47.5) | 1.6 | 7.3 | 1.5 | 5.6 |
| | E4 | MEK (30) | Toluene (70) | 1.5 | 5.8 | 1.6 | 5.7 |
| | E5 | Acetone (30) | Xylene (70) | 1.6 | 7.1 | 2.3 | 5.6 |
| Comparative Examples | CE1 | Acetone (70) | Toluene (30) | 1.7 | 7.2 | Open | 6.0 |
| | CE2 | Acetone (100) | None | 1.6 | 7.0 | Open | 5.0 |
| | CE3 | MEK (100) | None | 1.9 | 7.5 | Open | 5.2 |
| | CE4 | None | Toluene (100) | - | - | - | - |
| | CE5 | None | Xylene (100) | - | - | - | - |

| | | | | | | | |
|---|---|---|---|---|---|---|---|
| Thermocompression bonding was conducted under the same conditions of 180°C/10 seconds/1.5 MPa. In the case of E2 and E4, thermocompression bonding was conducted under the conditions of 180°C/20 seconds/1.5 MPa. | | | | | | | |
| E3: Ethyl acetate was used as a cosolvent and a mixed solvent of acetone (10%) and ethyl acetate (90%) was used as a good solvent. | | | | | | | |
| Open: 30 kΩ or more | | | | | | | |

As is apparent from the Tables described above, in the Examples of the present invention, neither a reduction in exotherm energy nor a large shift in exotherm peak temperature is observed even after exposed to light under a white fluorescent lamp of an illuminance of 1000 Ix at room temperature (25°C) (after storage) and both the electrical connection resistance and the peel adhesive strength were satisfactory. On the other hand, in Comparative Examples CE1 to 3, although initial properties were satisfactory, a reduction in exotherm energy was observed after exposure to light under a white fluorescent lamp for 24 hours, and the electrical connection resistance was high (open). Since toluene is used alone as the solvent in CE4 and xylene is used alone as the solvent in CE5, constituent components of the adhesive are not completely dissolved and a uniform adhesive solution and a uniform film could not be made. Therefore, DSC, the connection resistance, and the adhesive strength Were not measured. Thus, good effect of the anisotropically electroconductive adhesive film of the present invention was observed.

As verified in the foregoing pages, the cationic polymerizable adhesive , composition of the present invention can provide an adhesive film having excellent storage stability, which does not cause excess reaction even when exposed to visible light and does not lose a function as an adhesive.

## Claims

1. A cationic polymerizable adhesive composition comprising:
(a) a cationic polymerizable monomer selected from an epoxy monomer, a vinyl ether monomer, or a mixture thereof;
(b) a cationic polymerization catalyst being an iron-arene complex having an absorption peak in a visible light range of from 360 to 830 nm, and
(c) a solvent for the cationic polymerization catalyst,
wherein the solvent is a mixture of a good solvent and a poor solvent for the cationic polymerization catalyst, a good solvent being a solvent wherein the cationic polymerization catalyst has a solubility of 5% or more at room temperature, a bad solvent being a solvent wherein the cationic polymerization catalyst has a solubility of less than 5% at room temperature, and wherein a weight ratio of the good solvent to the poor solvent is within a range from 5:95 to 60:40.

2. An anisotropicallyelectroconductive adhesive composition comprising the cationic polymerizable adhesive composition claimed in claim 1 and electroconductive particles.

3. An adhesive film formed by applying the cationic polymerizable adhesive composition claimed in claim 1 onto a separator and drying the coating film.

4. An anisotropically electroconductive adhesive film formed by applying the anisotropically electroconductive adhesive composition claimed in claim 2, onto a separator and drying the coating film.

## Patentansprüche

1. Kationisch polymerisierbare Klebstoffzusammensetzung, umfassend:
(a) ein kationisch polymerisierbares Monomer, ausgewählt aus einem Epoxymonomer, einem Vinylethermonomer oder einem Gemisch davon;
(b) einen Katalysator für die kationische Polymerisation, welcher ein Eisen-Aren-Komplex mit einem Absorptions-Peak in einem Bereich des sichtbaren Lichts von 360 bis 830 nm ist; und
(c) ein Lösungsmittel für den Katalysator für die kationische Polymerisation,
wobei das Lösungsmittel ein Gemisch aus einem guten Lösungsmittel und einem schlechten Lösungsmittel für den Katalysator für die kationische Polymerisation ist, wobei ein gutes Lösungsmittel ein Lösungsmittel ist, in welchem der Katalysator für die kationische Polymerisation bei Raumtemperatur eine Löslichkeit von 5 % oder mehr aufweist, ein schlechtes Lösungsmittel ein Lösungsmittel ist, in welchem der Katalysator für die kationische Polymerisation bei Raumtemperatur eine Löslichkeit von weniger als 5 % aufweist, und wobei ein Gewichtsverhältnis des guten Lösungsmittels zu dem schlechten Lösungsmittel innerhalb eines Bereichs von 5:95 bis 60:40 liegt.

2. Anisotrop elektrisch leitfähige Klebstoffzusammensetzung, welche die in Anspruch 1 beanspruchte kationisch polymerisierbare Klebstoffzusammensetzung und elektrisch leitfähige Partikel umfasst.

3. Klebefilm, der durch Aufbringen der in Anspruch 1 beanspruchten kationisch polymerisierbaren Klebstoffzusammensetzung auf ein Trennmedium und Trocknen des Beschichtungsfilms gebildet wird.

4. Anisotrop elektrisch leitfähiger Klebefilm, der durch Aufbringen der in Anspruch 2 beanspruchten anisotrop elektrisch leitfähigen Klebstoffzusammensetzung auf ein Trennmedium und Trocknen des Beschichtungsfilms gebildet wird.

## Revendications

1. Composition adhésive polymérisable par polymérisation cationique, comprenant:
(a) un monomère polymérisable par polymérisation cationique sélectionné parmi un monomère époxy, un monomère d'éther vinylique, ou un mélange de ceux-ci ;
(b) un catalyseur de polymérisation cationique, lequel est un complexe fer-arène ayant un pic d'absorption dans une plage de lumière visible de 360 à 830 nm ; et
(c) un solvant pour le catalyseur de polymérisation cationique,
dans laquelle le solvant est un mélange d'un bon solvant et d'un solvant mauvais pour le catalyseur de polymérisation cationique, un bon solvant étant un solvant dans lequel le catalyseur de polymérisation cationique a une solubilité de 5 % ou plus à température ambiante, un solvant mauvais étant un solvant dans lequel le catalyseur de polymérisation cationique a une solubilité inférieure à 5 % à température ambiante, et dans laquelle un rapport pondéral du bon solvant contre le solvant mauvais est dans une plage de 5:95 à 60:40.

2. Composition adhésive anisotropiquement électroconductrice, comprenant la composition adhésive polymérisable par polymérisation cationique selon la revendication 1 et des particules électroconductrices.

3. Film adhésif formé par application de la composition adhésive polymérisable par polymérisation cationique selon la revendication 1 sur un séparateur et séchage du film de recouvrement.

4. Film adhésif anisotropiquement électroconducteur formé par application de la composition adhésive anisotropiquement électroconductrice selon la revendication 2 sur un séparateur et séchage du film de recouvrement.
